# EUROPÄISCHE PATENTSCHRIFT

(11) **EP 1 270 095 B1**
(45) Veröffentlichungstag und Bekanntmachung des Hinweises auf die Patenterteilung: **13.09.2006**
(21) Anmeldenummer: 02012232.1
(22) Anmeldetag: 04.06.2002
(51) Int. Cl.: B08B 7/00, H05H 1/24, H01J 37/32

(54) **Verfahren zur Überwachung einer Vorbehandlung mit einem Plasmastrahl**
Method of monitoring a pretreatment with a plasma jet
Procédé de surveillance d'un prétraitement avec un jet de plasma

(30) Priorität: 23.06.2001 DE 10130402
(43) Veröffentlichungstag der Anmeldung: 02.01.2003
(73) Patentinhaber: Bayerische Motoren Werke Aktiengesellschaft, 80809 München (DE)
(72) Erfinder: Zisch, Peter, 80939 München (DE)

(56) Entgegenhaltungen:
- EP-A- 0 308 516
- WO-A-00/50667
- DE-A- 19 502 133
- DE-A- 19 532 412
- US-A- 4 396 478

## Beschreibung

Die Erfindung betrifft ein Verfahren zur Überwachung einer Vorbehandlung einer zu verklebenden Oberfläche gemäß des Oberbegriffs des Patentanspruchs 1.

Aus der DE 195 32 412 A1 ist ein Verfahren und eine Vorrichtung zur Vorbehandlung von zu verklebenden Oberflächen mit einem sogenannten Plasmastrahl bekannt. Nach dem heutigen Erkenntnisstand handelt es sich bei dem Plasmastrahl höchstwahrscheinlich nicht um ein Plasma im eigentlichen Sinne, sondern nur um einen Strahl mit Ionen, Radikalen und angeregten Atomen. Da sich der Begriff aber bereits zur Bezeichnung dieses Verfahrens zur Vorbehandlung von zu verklebenden Oberflächen eingebürgert hat, wird er auch hier weiterhin so verwendet. Dieses Verfahren ist sehr elegant im Vergleich zur klassischen Vorbehandlungsmethode einer zu verklebenden Oberfläche mit Reiniger (meist Isopropanol-Wasser) und Aktivator, bei der jeweils Ablüftzeiten akribisch eingehalten werden mussten und schwer zugängliche Bereiche häufig nur unzureichend vorbehandelt werden konnten.

Alle Vorbehandlungsverfahren haben gemeinsam, dass die Dosierung der Vorbehandlung entscheidend für die spätere Festigkeit und Dauerbeständigkeit der Verklebung ist. Dabei kann eine zu verklebende Oberfläche sowohl nicht ausreichend vorbehandelt, als auch übervorbehandelt sein, was in beiden Fällen die Qualität der Verklebung negativ beeinflusst.

Es wird auf vielerlei Art und Weise versucht, eine vorbehandelte Oberfläche kontrollieren zu können. So gibt es beispielsweise Aktivatoren mit Zusätzen, die unter Einwirkung von ultraviolettem Licht im sichtbaren Lichtspektrum leuchten. Damit kann kontrolliert werden, ob die zu verklebende Oberfläche wirklich überall aktiviert wurde. Es ist allerdings keine Aussage möglich, ob die richtige Menge an Aktivator verwendet wurde. Darüber hinaus sind keine Kontrollmöglichkeiten bekannt, die ohne Zerstörung der Oberfläche bzw. der Verklebung durchgeführt werden können.

Der Erfindung liegt die Aufgabe zugrunde, ein Verfahren zur Überwachung einer Vorbehandlung einer zu verklebenden Oberfläche zu schaffen.

Diese Aufgabe wird erfindungsgemäß gelöst durch das Verfahren gemäß Patentanspruch 1.

Eine zu verklebende Oberfläche wird mit einem Plasmastrahl behandelt. Kerngedanke der Erfindung ist es, dass die mit der Zeitdauer der Plasmabehandlung ansteigende Temperatur der Oberfläche erfasst wird und zur Beurteilung der Qualität der Vorbehandlung dient. Maßgeblich ist dabei der Temperaturanstieg im Vergleich zur Temperatur der Oberfläche vor der Vorbehandlung und nicht die absolute Temperatur, da diese von der Umgebungstemperatur und vielen anderen Faktoren abhängt, die zur Beurteilung der Qualität der Vorbehandlung keine Rolle spielen. Die Erfassung der Temperatur muss dabei zeitnah zur Vorbehandlung der Oberfläche erfolgen, da sich die Oberfläche ansonsten bereits wieder abgekühlt haben kann.

Diese zerstörungsfreie und einfache Möglichkeit zur Beurteilung der Qualität einer Vorbehandlung mit einem Plasmastrahl ermöglicht eine 100% Kontrolle der vorbehandelten Oberfläche und erhöht so die Prozesssicherheit. Wenn eine nicht ausreichende Vorbehandlung festgestellt wird, ist eine gezielte Nacharbeit möglich, ohne dass das unterbehandelte Werkstück verworfen werden muss. Durch die so erzielbare höhere Prozesssicherheit können auch kostengünstigere Klebstoffe eingesetzt werden, für die eine exaktere Vorbehandlung erforderlich ist.

Die Qualität der Vorbehandlung gilt als fehlerfrei, wenn die Temperatur der Oberfläche bei der Plasmabehandlung einen Mindestwert überschritten hat und unter einem Maximalwert geblieben ist. Bleibt die Temperatur unter dem Mindestwert, ist die Oberfläche nicht ausreichend vorbehandelt worden. Es besteht die Gefahr, dass die Oberfläche noch lokal verschmutzt ist, oder nicht ausreichend reaktiv ist. Die Temperatur steigt auf einer verschmutzten Oberfläche langsamer an, da ein Teil der mit dem Plasmastrahl aufgebrachten Energie mit den Schmutzpartikeln abgeführt wird. Die Verklebung könnte nach einem Kataplasmatest ein adhäsives Bruchbild zeigen. Ist dagegen ein Maximalwert überschritten worden, ist die Oberfläche übervorbehandelt worden. Es besteht die Gefahr, dass die Oberfläche dabei beschädigt wurde, sodass die Verklebung nicht ganz sicher hält.

Idealerweise erfolgt die Beurteilung der Qualität über die Erfassung der Temperatur während der Vorbehandlung der Oberfläche, sodass der Plasmastrahl in Abhängigkeit davon geregelt werden kann. Dies ist insbesondere für vollautomatisierte Anwendungen von Bedeutung. Es setzt allerdings voraus, dass der gewünschte Bereich des Temperaturanstiegs der Oberfläche durch Vorversuche ermittelt wurde, in dem eine sichere Verklebung möglich ist (=100% kohäsives Bruchbild nach Kataplasmatest). Auch die Behandlung einer zu verklebenden Oberfläche, die aus unterschiedlichen Materialen besteht, ist so prozessicher problemlos möglich. Beispielsweise können so in der Automobilindustrie Kunststoffteile, wie Dichtungen, direkt am Band auf unterschiedlichen Lacken zu verklebt werden. Die Unterschiede im Lack bzw. in den Lacken werden praktisch zeitgleich zur Vorbehandlung erfasst, und der Plasmastrahl wird permanent entsprechend geregelt.

Vorteilhafterweise kann der Plasmastrahl in der Intensität und / oder in der Positionierung relativ zur Oberfläche geregelt werden. Die Intensität kann sowohl durch die Höhe der angelegten Spannung als auch durch die Stärke der Durchströmung variiert werden. Die Positionierung relativ zur Oberfläche kann einerseits durch den Abstand zur Oberfläche und andererseits durch die Geschwindigkeit, mit der das Werkstück quer zum Plasmastrahl bewegt wird, verändert werden. Über die Geschwindigkeit lässt sich lokal die Vorbehandlungsdauer der Oberfläche verändern.

In einer günstigen Ausführung wird die Temperatur der Oberfläche berührungslos mit einem Infrarotsensor oder einer Infrarotkamera erfasst. Ein atmosphärischer Plasmastrahl beeinflusst nicht den infraroten Wellenbereich. Dadurch ist dieser Wellenbereich besonders zur Erfassung der Temperatur der Oberfläche geeignet. Alternativ kann die Temperatur auch indirekt an der Unterseite des Werkstücks mit der vorzubehandelnden Oberfläche gemessen werden. Auch dies ist eine sehr geeignete und zugleich einfache Methode der Temperaturmessung.

Weitere vorteilhafte Ausgestaltungen sind Gegenstand von Unteransprüchen.

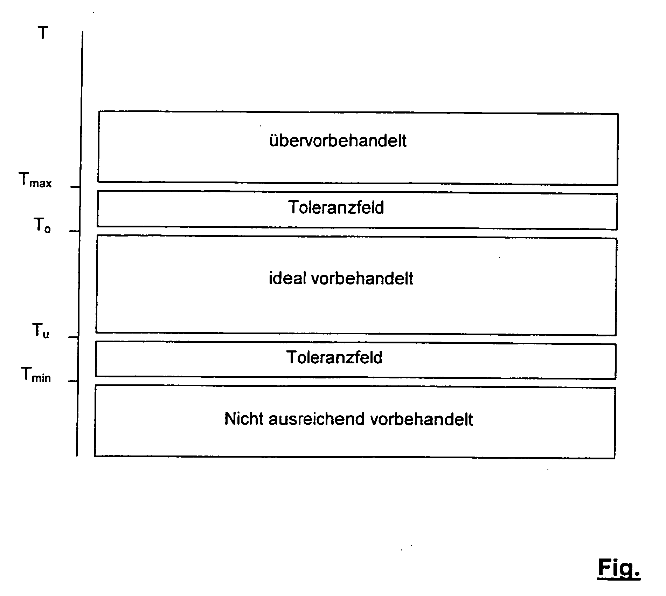

In der Zeichnung ist ein Ausführungsbeispiel der Erfindung dargestellt, das im folgenden näher beschrieben wird. Die einzige Figur zeigt in schematischer Darstellungsweise in einem Diagramm die Abhängigkeit der Qualität der Vorbehandlung einer zu verklebenden Oberfläche von der mit der Zeitdauer der Plasmabehandlung ansteigende Temperatur der Oberfläche.

In dem Diagramm ist nach oben die Temperatur T der vorbehandelten Oberfläche aufgetragen. Die ideale Temperatur T der Oberfläche liegt unmittelbar nach der Behandlung mit einem Plasmastrahl im Bereich zwischen Tᵤ und Tₒ. An diesen Bereich schließt sich nach oben bis Tₘₐₓ und nach unten bis Tₘᵢₙ je ein Toleranzfeld an. Innerhalb dieser beiden Toleranzfelder ist die Vorbehandlung nicht optimal, aber noch ausreichend für eine sichere Verklebung. Liegt die Temperatur T oberhalb von Tₘₐₓ, ist die Oberfläche zu lange mit dem Plasmastrahl vorbehandelt worden. Es besteht die Gefahr, dass die Qualität der Verklebung insbesondere nach einem Kataplasmatest nicht mehr den Anforderungen genügt. Liegt die Temperatur T dagegen unterhalb von Tₘᵢₙ, ist die Oberfläche nicht ausreichend lang vorbehandelt worden. Es besteht die Gefahr, dass noch Reste von Schmutzpartikeln sich auf der Oberfläche befinden oder der Energieeintrag durch die Plasmavorbehandlung nicht ausreichend ist, um eine sichere Verklebung zu gewährleisten.

Die zum Erreichen einer bestimmten Temperatur T der Oberfläche erforderliche Behandlungsdauer bzw. -intensität mit einem Plasmastrahl kann selbst bei gleichen Werkstücken stark variieren. Befinden sich beispielsweise lokal auf der Oberfläche vereinzelt noch Reste von Lösungs- oder Trennmitteln, müssen diese Bereiche wesentlich länger vorbehandelt werden, bis diese Reste vollständig entfernt sind, als andere Bereiche ohne derartige Reste. Auch die Bereiche der Oberfläche, an denen womöglich ein Arbeiter die Werkstücke zuvor mit leicht verschwitzten Fingern beispielsweise zum Einlegen in eine Maschine angelangt hat, bedürfen einer wesentlich gründlicheren Vorbehandlung, als andere Bereiche. Sogar scheinbar gleiche Werkstücke können in ihrer Beschaffenheit und damit der erforderlichen Vorbehandlungsdauer bzw. -intensität stark schwanken. So spielt beispielsweise bei lackierten Blechteilen eine auch nur geringfügig schwankende Lackdicke eine erhebliche Rolle.

Daher ist das erfindungsgemäße Verfahren zur Überwachung der Vorbehandlung mit einem Plasmastrahl einer zu verklebenden Oberfläche durch eine Messung der Temperatur T der Oberfläche sowie die Integration dieses Verfahrens in die Regelung des Plasmastrahls maßgeblich, um mit einem hohen Automatisierungsgrad prozesssicher Verklebungen herstellen zu können.

## Patentansprüche

1. Verfahren zur Überwachung einer Vorbehandlung einer zu verklebenden Oberfläche mit einem Plasmastrahl, **dadurch gekennzeichnet, dass** die mit der Zeitdauer der Plasmabehandlung ansteigende Temperatur der Oberfläche erfasst wird und zur Beurteilung der Qualität der Vorbehandlung dient.

2. Verfahren nach Anspruch 1, wobei die Qualität der Vorbehandlung als fehlerfrei gilt, wenn die Temperatur der Oberfläche bei der Plasmabehandlung einen Mindestwert überschritten hat und unter einem Maximalwert geblieben ist.

3. Verfahren nach einem der vorhergehenden Ansprüche, wobei der Plasmastrahl in Abhängigkeit von der Temperatur der Oberfläche geregelt wird.

4. Verfahren nach Anspruch 3, wobei die Intensität des Plasmastrahls geregelt wird.

5. Verfahren nach Anspruch 3 oder 4, wobei die Positionierung des Plasmastrahls relativ zur Oberfläche geregelt wird.

6. Verfahren nach einem der vorhergehenden Ansprüche, wobei die Temperatur der Oberfläche mit einem Infrarotsensor oder einer Infrarotkamera erfasst wird.

7. Verfahren nach Anspruch 1 oder 2, wobei die Temperatur indirekt an der Unterseite des Werkstücks mit der vorzubehandelnden Oberfläche gemessen wird.

## Claims

1. A method of monitoring the pretreatment of a surface for sticking with a plasma beam, **characterised in that** the temperature of the surface, which increases with the duration of plasma treatment, is measured and used to judge the quality of pretreatment.

2. A method according to claim 1, wherein the pretreatment is regarded as fault-free if the surface temperature during plasma treatment exceeds a minimum value and remains below a maximum value.

3. A method according to any of the preceding claims, wherein the plasma beam is adjusted in dependence on the surface temperature.

4. A method according to 3, wherein the intensity of the plasma beam is adjusted.

5. A method according to claim 3 or claim 4, wherein the positioning of the plasma beam relative to the surface is adjusted.

6. A method according to any of the preceding claims, wherein the surface temperature is detected with an infrared sensor or an infrared camera.

7. A method according to claim 1 or claim 2, wherein the temperature on the underside of the workpiece having the surface for pretreating is measured indirectly.

## Revendications

1. Procédé de surveillance d'un prétraitement d'une surface à coller avec un jet de plasma,
**caractérisé en ce que**
la température de la surface augmente au fur et à mesure du traitement au plasma et sert à évaluer la qualité du prétraitement.

2. Procédé selon la revendication 1,
selon lequel la qualité du prétraitement est considérée comme sans défaut lorsque la température de la surface a dépassé une valeur minimale lors du traitement au plasma et est restée sous une valeur maximale.

3. Procédé selon l'une quelconque des revendication précédentes,
selon lequel le jet de plasma est réglé en fonction de la température de la surface.

4. Procédé selon la revendication 3,
selon lequel l'intensité du jet de plasma est réglée.

5. Procédé selon la revendication 3 ou 4,
selon lequel le positionnement du jet de plasma est réglé par rapport à la surface.

6. Procédé selon l'une quelconque des revendications précédentes,
selon lequel la température de la surface est détectée avec un capteur infrarouge ou une caméra infrarouge.

7. Procédé selon la revendication 1 ou 2,
selon lequel la température est mesurée indirectement sur le dessous de la pièce présentant la surface à prétraiter.
